(19) Europäisches Patentamt

European Patent Office

Office européen des brevets

(11) **EP 0 818 886 A2**

(12) **EUROPÄISCHE PATENTANMELDUNG**

(43) Veröffentlichungstag:
**14.01.1998 Patentblatt 1998/03**

(51) Int. Cl.$^6$: **H03H 17/02**

(21) Anmeldenummer: **97109619.3**

(22) Anmeldetag: **13.06.1997**

(84) Benannte Vertragsstaaten:
**AT BE CH DE DK ES FI FR GB GR IE IT LI LU MC NL PT SE**

(30) Priorität: **10.07.1996 DE 19627788**

(71) Anmelder: **ROBERT BOSCH GMBH**
**70442 Stuttgart (DE)**

(72) Erfinder: **Göckler, Heinz**
**71522 Backnang (DE)**

(54) **Umschaltbare Frequenzweiche**

(57) Die Erfindung betrifft eine umschaltbare Frequenzweiche, die aus zwei Einzelfiltern besteht, deren Mittenfrequenz $f_m=(2m-1)\,f_a/8$, mit $m=1,2,3,4$ gewählt sind. Sie zeichnet sich insbesondere dadurch aus, daß durch Ändern von Vorzeichen einiger weniger Verknüpfungseinrichtungen das Durchlaßband der Filterübertragungsfunktion in einen anderen Frequenzbereich verschiebbar ist.

Fig. 1

**Beschreibung**

Stand der Technik

Die Erfindung betrifft eine umschaltbare Frequenzweiche nach dem Oberbegriff des Anspruchs 1 beziehungsweise des Anspruchs 2.

Derartige Filterweichen werden dazu eingesetzt, um zwei komplexwertige Signale zu einem Frequenzmultiplex-Signal (im folgenden kurz FDM-Signal genannt) mit doppelter Abtastfrequenz $f_a$ zusammenzufassen. Diese Frequenzweichen werden beispielsweise im Bereich des Richtfunks oder bei Point-to-Multipoint-Verbindungen eingesetzt.

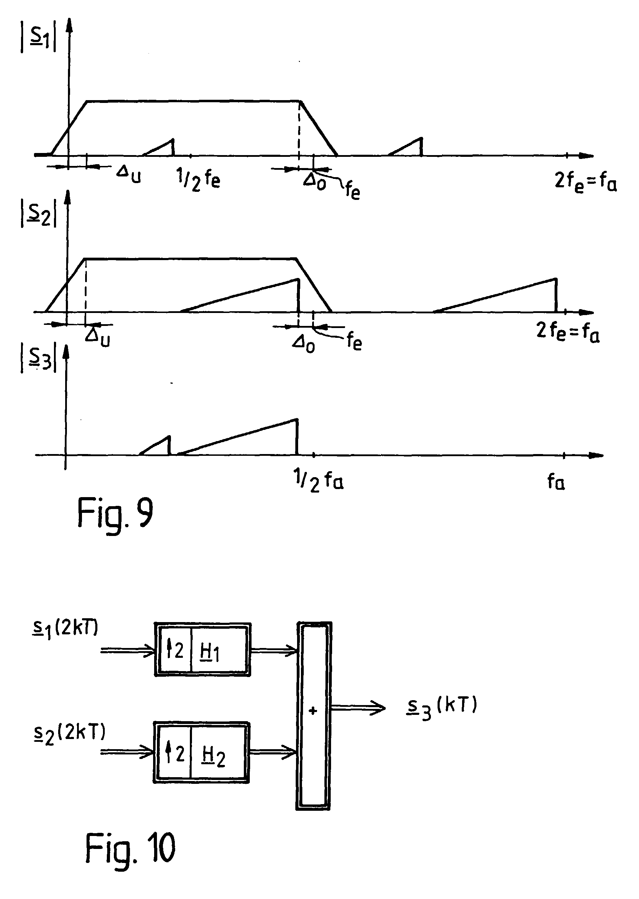

Grundsätzlich erfordern sie eine geeignete Vorverarbeitung der zusammenzufassenden Signale derart, daß die Bandbreiten B1 beziehungsweise B2 der beiden Signale jeweils begrenzt sind auf einen Wert $f_e/2$, wobei $f_e$ die Abtastfrequenz der Signale ist. Für das Zusammenfassen ist es darüber hinaus notwendig, daß die Summe der beiden Bandbreiten $B1+B2 \leq f_a/2 = f_e$ gilt und daß sich die beiden Nutzspektren der Eingangssignale nicht überlappen. Eine mögliche Spektralkonstellation solcher Signale ist in Figur 9 beispielhaft dargestellt. Deutlich zu erkennen ist darin, daß die beiden Spektren der Einzelsignale innerhalb eines Bereichs von 0 bis $f_e$ liegen. Beide Einzelsignale durchlaufen jeweils ein Filter mit der gleichen Übertragungsfunktion $\underline{H}$, die in Figur 9 ebenfalls eingezeichnet ist.

Zur Erleichterung (Aufwandsbegrenzung) der Interpolationsfilterung zur Abtastratenerhöhung sind zusätzlich sogenannte Guard-Bänder $\Delta_u$ und $\Delta_o$ vorgesehen, die spektralfrei sind.

Figur 10 zeigt dazu eine bekannte Realisierung einer Fiiterweiche, die zwei identische Einzelfilter F1 und F2 mit den Übertragungsfunktionen $\underline{H}1=\underline{H}2=\underline{H}$ aufweist und deren Ausgangssignale mittels eines Addierers zusammengefaßt werden.

Aufgrund der großen Breite des Durchlaßbereichs besteht die Forderung, die Filter so zu konfigurieren, daß sie einen sehr schmalen Übergangsbereich und damit auch sehr schmale Guard-Bänder besitzen. Dies führt zu einem sehr hohen Filterwaufwand, bedingt durch die Steilheit der Filterflankenbereiche.

Eine Verringerung des Aufwands läßt sich dadurch erzielen, daß die beiden Filterfunktionen $\underline{H}1$ und $\underline{H}2$ mittels ladbarer Koeffizienten veränderbar sind. In diesem Fall kann die Bandbreite und die Mittenfrequenz der beiden Filter dann jeweils mit den entsprechenden Werten der zusammenzufassenden Signalspektren übereinstimmen. Obgleich damit der Filtergrad und damit die Anzahl der Filterkoeffizienten reduziert wird, erfordert die Bereitstellung der Koeffizientensätze und das Laden und das Steuern der Filter einen großen Aufwand.

Vorteile der Erfindung

Die erfindungsgemäße umschaltbare Frequenzweiche mit den Merkmalen des Anspruchs 1 beziehungsweise des Anspruchs 2 hat demgegenüber den Vorteil, daß der Schaltungsaufwand für die Filterweiche stark verringert ist.

Dadurch, daß -wie in Anspruch 1 angegeben- die beiden Filter als komplexe Halbbandfilter mit einer Mittenfrequenz $f_m=(2m-1)f_a/8$ realisiert sind, wobei fa die verdoppelte Eingangs- beziehungsweise die einfache Ausgangsabtastfrequenz und $m=0,\pm1,\pm2,..$ ist, läßt sich die Nutzbandbreite der entsprechenden beiden Filter jeweils halbieren, so daß der Flankenbereich jeweils wesentlich breiter ausfallen kann. Damit verringert sich erfindungsgemäß der Filteraufwand beträchtlich. Darüber hinaus wird ein weiterer Vorteil dadurch erzielt, daß die Guard-Bänder nicht mehr notwendig sind.

Ein weiterer Vorteil ist darin zu sehen, daß die Übertragungsfunktion eines Filters auf einfache Weise durch Änderung einiger Vorzeichen bestimmter Filterkoeffizienten auf die Übertragungsfunktion des anderen Filters oder auf eine andere Mittenfrequenz $f_m$ umschaltbar ist.

Durch die in Anspruch 2 angegebene Lösung läßt sich ein weiterer Vorteil hinsichtlich des Filteraufwands dadurch erzielen, daß die beiden Einzelfilter zu einer Filterweiche zusammengefaßt sind. Zusätzlich läßt sich auch die Umschaltung auf eine andere Übertragungsfunktion durch eine Vorzeichenänderung an lediglich zwei Addierern erzielen.

Weitere Vorteile und Ausgestaltungen der Erfindung ergeben sich aus den Unteransprüchen.

Zeichnung

Die Erfindung wird nun anhand von Ausführungsbeispielen mit Bezug auf die Zeichnungen näher erläutert. Dabei zeigen:

Figur 1      eine schematische Darstellung eines einzelnen Filters der erfindungsgemäßen Frequenzweiche;

Figur 2      eine schematische Darstellung einer Frequenzweiche gemäß einem zweiten Ausführungsbeispiel;

Figur 3      eine schematische Darstellung der Umschaltfunktion;

Figur 4       ein Spektraldiagramm;

Figur 5       ein weiteres Spektraldiagramm;

Figur 6       ein weiteres Spektraldiagramm;

Figur 7       eine schematische Darstellung eines Demultiplexers zum Trennen des Signals in zwei Einzelsignale;

Figur 8       eine schematische Darstellung der Umschaltmöglichkeit;

Figur 9       eine Spektraldarstellung einer Filterweiche nach dem Stand der Technik, und

Figur 10      eine schematische Darstellung einer Frequenzweiche nach dem Stand der Technik.

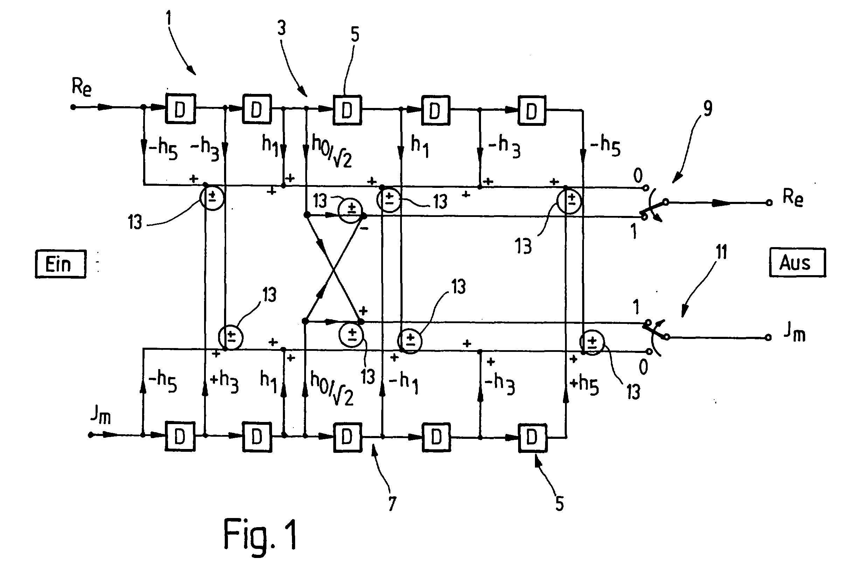

In Figur 1 ist ein komplexes Halbbandfilter 1 ($\underline{H}_1$) gezeigt, das ein komplexes Eingangssignal mit der Abtastrate $f_e=1/(2T)=1/D$ in ein komplexes Ausgangssignal mit der Abtastrate $f_a=2f_e=1/T=2/D$ umsetzt. Das Filter 1 mit der ungeraden Filterlänge N = 11 umfaßt für das reellwertige Eingangssignal eine Kette, 3 mit $(N-1)/2=5$ Verzögerungsgliedern 5 mit der Verzögerungszeit D und für das imaginäre Eingangssignal eine Kette 7 mit ebenfalls $(N-1)/2=5$ Verzögerungsgliedern 5.

Die mit Filterkoeffizienten $\underline{h}(k)$ bewerteten Signale der Verzögerungsketten 3,7 werden zwei Multiplexern 9,11 zugeführt, die die Abtastratenverdoppelung auf eine Abtastrate von $f_a=1/T$ durchführen, indem jeweils zwei Teilsignalfolgen zeitlich ineinander verschachtelt werden (Polyphasenmethode).

Die komplexwertigen Koeffizienten $\underline{h}(l)$ dieses nichtrekursiven Halbbandfilters 1 sind für l ungleich 0 entweder rein reell oder rein imaginär, wobei $-(N-1)/2 \leq l \leq (N-1)/2$ ist. Damit sind die Koeffizienten nicht im üblichen Sinne komplexwertig, so daß damit eine Aufwandsverringerung, insbesondere im Hinblick auf die notwendigen Multiplizierer, erreichbar ist. Lediglich der Koeffizient h(0) ist komplexwertig gemäß

$$\underline{h}(0)=\pm(c_0 \pm jc_0).$$

Unter Zugrundelegung einer auf die Abtastfrequenz bezogenen Mittenfrequenz $f_m=(2m-1)f_a/8$ mit $m=0,\pm1,\pm2,\pm3,...$ ergibt sich abgeleitet vom Halb-Band-Filter durch Modulation der Impulsantwort dieses Filters auf einen komplexwertigen Träger der Frequenz $f_m$ folgende Gleichung:

$$\underline{h}(l)=h(l)\ e^{\ j[2\pi lf_m/f_a + \varphi_0]}$$
$$= e^{\ jl(2m-1)\pi/4}\ e^{\ j\varphi_0}h(l)$$
$$= e^{\ j[l(2m-1)+(2k-1)]\pi/4}\ h(l)$$

das heißt mit $\varphi_0=(2k-1)\pi/4$ , wobei $k=0,\pm1,\pm2,....$

Aus der Linearphasigkeit des Filters ergibt sich darüber hinaus h(l)=h(-l) und aus der Halb-Band-Filter-Eigenschaft h(l)=0 für $l=\pm2,\pm4,\pm6,...$

Für l=0 liefert die oben genannte Gleichung folgenden Wert:

$$\underline{h}(0)=e^{\ j(2k-1)\pi/4}\ h(0)$$

$$= h(0)[\cos(2k-1)\pi/4+j\sin(2k-1)\pi/4]$$

$$= h(0)[\sin(2k+1)\pi/4+j\sin(2k-1)\pi/4]$$

$$= \pm\frac{h(0)}{\sqrt{2}}\ (1\pm j).$$

Dabei ist das Vorzeichen abhängig von $k=0,\pm1,\pm2,...$, wobei k die Nullphase $\varphi_0$ festlegt.

Unter Berücksichtigung der vorgenannten Gleichungen und der linearen Phase des Filters ergibt sich folgende Tabelle bezüglich der Filterkoeffizienten

| I | $\underline{h}$(l) |
|---|---|
| -5 | $-h(-5)=-h(5)=-h_5$ |
| -3 | $-jh(-3)=-jh(3)=-jh_3$ |
| -1 | $h(-1)=h(1)=h_1$ |
| 0 | $h(0)/\sqrt{2}+jh(0)/\sqrt{2}$ |
| 1 | $jh(1)=jh_1$ |
| 3 | $-h(3)=-h_3$ |
| 5 | $-jh(5)=-jh_5$ |

Die Tabelle ist exemplarisch erstellt für ein Filter der Filterlänge N=11 und k=m=1 entsprechend $f_1=f_a/8$ .

In Figur 1 sind deutlich Verknüpfungspunkte 13 zu erkennen, in denen jeweils zwei Vorzeichen eingetragen sind. Die jeweils oberen Vorzeichen "+" gelten für den Fall m=1, das heißt einer Mittenfrequenz von $f_1=f_a/8$ .

Wie im Zusammenhang mit der Figur 10 bereits angedeutet, besteht die Frequenzweiche aus zwei Einzelfiltern F1 und F2, deren Ausgangssignale zu einem gemeinsamen Signal zusammengefaßt werden. Jedes dieser Einzelfilter F1,F2 ist in der vorgenannten Form gemäß Figur 1 ausgebildet, wobei sich die Mittenfrequenzen der Filter jedoch beispielsweise um $\Delta f_m=f_a/4$ unterscheiden können.

Wird nun das zweite Filter F2 mit einer Mittenfrequenz $f_2=(3/8)f_a$ gewählt, so entspricht dieses Filter der in Figur 1 gezeigten Anordnung, wobei jedoch die unteren Vorzeichen "-" in den Verknüpfungspunkten 13 verwendet werden.

Daraus wird ersichtlich, daß durch Einstellen beziehungsweise Verändern der in den acht Verknüpfungspunkten 13 angegebenen Vorzeichen die Übertragungsfunktion $\underline{H}_1$ mit einer Mittenfrequenz $f_1=f_a/8$ oder die Übertragungsfunktion $\underline{H}_2$ mit einer Mittenfrequenz $f_2=3f_a/8$ geschaltet werden kann.

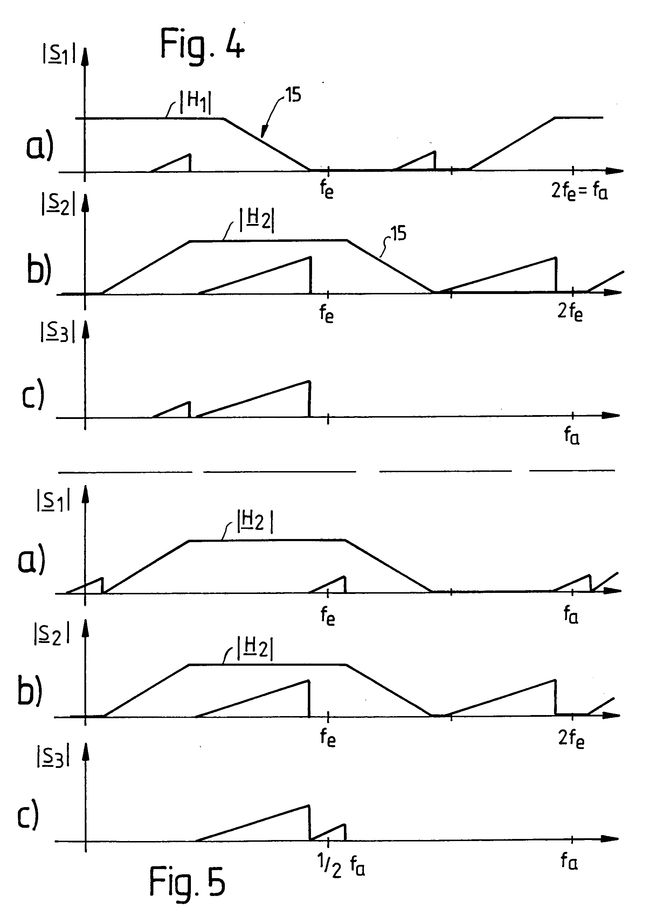

In den Figuren 4 und 5 sind entsprechende Spektraldiagramme einer Frequenzweiche mit zwei parallel angeordneten Filtern F1 und F2 angegeben.

So weist das Filter F1 mit der Übertragungsfunktion $\underline{H}$1 eine Mittenfrequenz von $f_a/8$ auf, während das parallele Filter F2 eine Übertragungsfunktion $\underline{H}$2 mit einer Mittenfrequenz $f_2=3f_a/8$ aufweist. Die beiden Signale $\underline{s}$1 und $\underline{s}$2 werden dann entsprechend gefiltert, so daß am Ausgang der Frequenzweiche das aus beiden Einzelsignalen zusammengesetzte Signal $\underline{s}$3 anliegt.

Deutlich zu erkennen ist ein -gegenüber dem in Figur 9 angegebenen- sehr viel schmälerer Nutzbandbereich, so daß ein Flankenbereich 15 wesentlich breiter sein kann. Daraus ergibt sich die gewünschte Aufwandsverringerung des Filters.

Liegen die beiden Eingangssignale $\underline{s}$1 und $\underline{s}$2 jedoch beispielsweise in der oberen Hälfte des Eingangsbandes, so läßt sich durch Ändern der Vorzeichen in den Verknüpfungspunkten 13 eines Filters dessen Übertragungsfunktion umschalten. In dem in Figur 5 dargestellten Beispiel entspricht nun die Übertragungsfunktion des Filters F1 derjenigen des Filters F2.

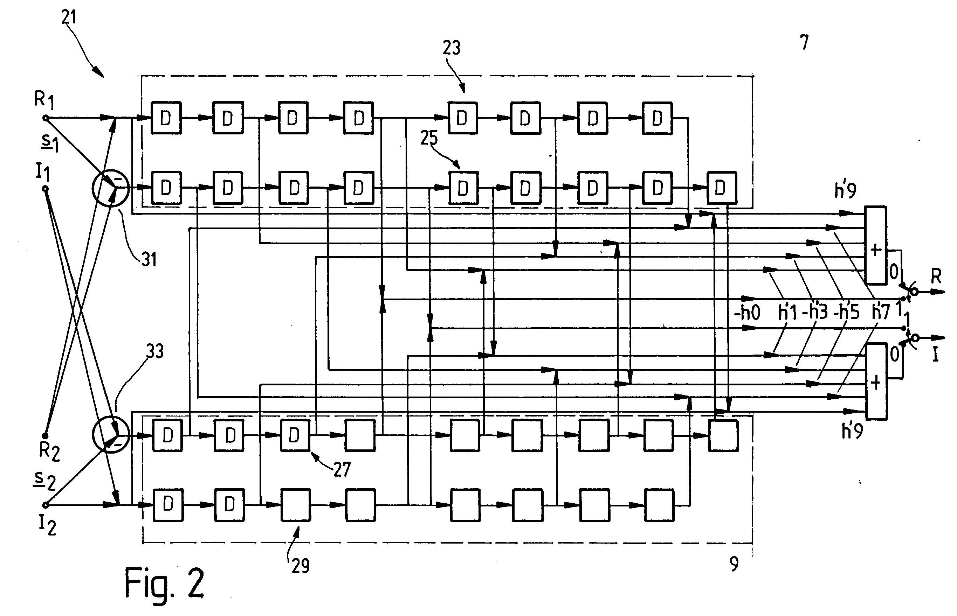

In Figur 2 ist ein weiteres Ausführungsbeispiel einer Frequenzweiche dargestellt. Hierbei handelt es sich um eine Zusammenschaltung zweier nichtrekursiver Halbbandfilter, wie sie in Figur 1 dargestellt sind. Dabei wird die Eigenschaft ausgenutzt, daß sich die Filterkoeffizienten bei unterschiedlichen Mittenfrequenzen gemäß der zuvor genannten Formel lediglich im Vorzeichen unterscheiden.

Um dies deutlicher erkennen zu können, wird die zuvor genannte Formel umgeformt beziehungsweise der Wert der Nullphase mit

$$\varphi_0=(2m-1)\pi/4+k\pi/2$$

ebenfalls in Abhängigkeit von m=0,±1,±2,...gewählt, also von der Lage der Mittenfrequenz $f_m=(2m-1)f_a/8$ der Teilübertragungsfunktion. Damit folgt aus obiger Formel für die komplexwertigen Koeffizienten

$$\underline{h}_m(l)=h(l)e^{jl(2m-1)\pi/4+\varphi_0}$$
$$=h(l)j^k e^{j(l+1)(2m-1)\pi/4}$$

Die gezeigte Frequenzweiche 21 weist im vorliegenden Ausführungsbeispiel eine Filterlänge von N = 19 auf und umfaßt insgesamt vier Verzögerungsgliedketten 23,25,27 und 29. Die beiden äußeren Verzögerungsgliedketten 23,29 umfassen jeweils (N-3)/2=8 Verzögerungsglieder mit der Verzögerungszeit $D=1/f_e$. Die Verzögerungsgliedkette 23 wird gespeist mit dem Summensignal der beiden Realteile der Eingangssignale, während die untere Verzögerungsgliedkette 29 mit dem Summensignal der beiden Imaginärteile der Eingangssignale gespeist wird.

Die beiden anderen Verzögerungsgliedketten 25 und 27 umfassen jeweils ein Verzögerungsglied mehr, so daß sie insgesamt (N-1)/2=9 Verzögerungsglieder mit der Verzögerungszeit D besitzen.

Gespeist wird die Verzögerungsgliedkette 25 mit einem Signal, das in einem Verknüpfungspunkt 31 aus den beiden Realteilen der Eingangssignale gebildet wird. Entsprechend werden die beiden Imaginärteile der Einzelsignale in einem Verknüpfungspunkt 33 zusammengefaßt und der Verzögerungsgliedkette 27 zugeführt.

Abhängig von der in diesen Verknüpfungspunkten 31,33 durchgeführten Verknüpfung läßt sich die Übertragungsfunktion $\underline{H}1$ (Mittenfrequenz $f_1=3f_a/8$) oder $\underline{H}2$ (Mittelfrequenz $f_2=5f_a/8$) auf die Eingangssignale anwenden.

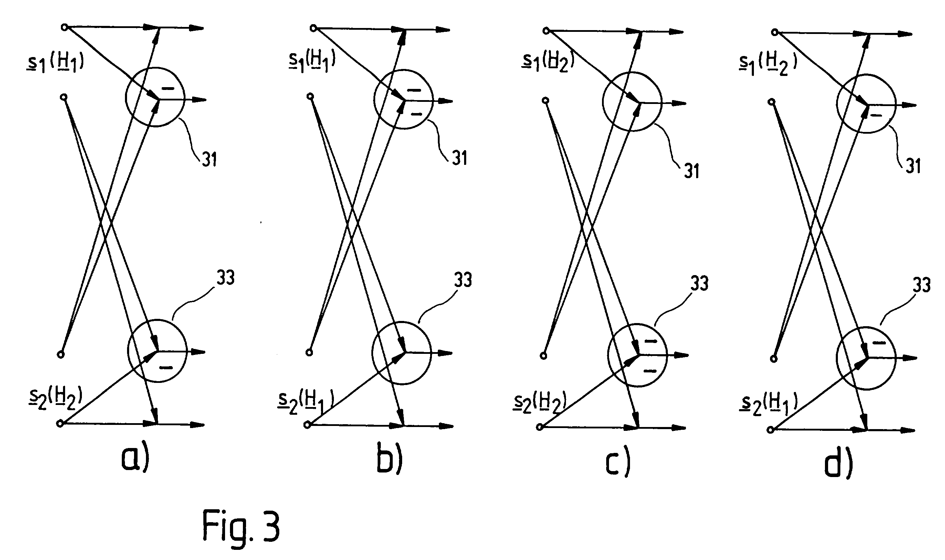

Die Figur 3 zeigt die vier möglichen Kombinationen der Übertragungsfunktionen $\underline{H}1$ und $\underline{H}2$. So wird im Fall gemäß Figur 3a auf das Signal $\underline{s}1$ die Übertragungsfunktion $\underline{H}1$ und auf das Signal $\underline{s}2$ die Übertragungsfunktion $\underline{H}2$ angewendet. Bei der in Figur 3b gezeigten Einstellung der Vorzeichen in den Verknüpfungspunkten 31 und 33 wird auf beide Eingangssignale die Übertragungsfunktion $\underline{H}1$ angewendet, während im in Figur 3c gezeigten Fall beide Übertragungsfunktionen $\underline{H}2$ sind. Die letzte Möglichkeit ist in Figur 3d dargestellt, wobei die Übertragungsfunktion $\underline{H}2$ dem oberen Eingangssignal und die Übertragungsfunktion $\underline{H}1$ dem unteren Eingangssignal zugeordnet ist.

Dieser Figur ist deutlich zu entnehmen, daß eine Umschaltung zwischen der Übertragungsfunktion $\underline{H}1$ und der Übertragungsfunktion $\underline{H}2$ auf sehr einfache Art möglich wird, indem lediglich die Vorzeichen in den Verknüpfungspunkten 31 und 33 verändert werden müssen.

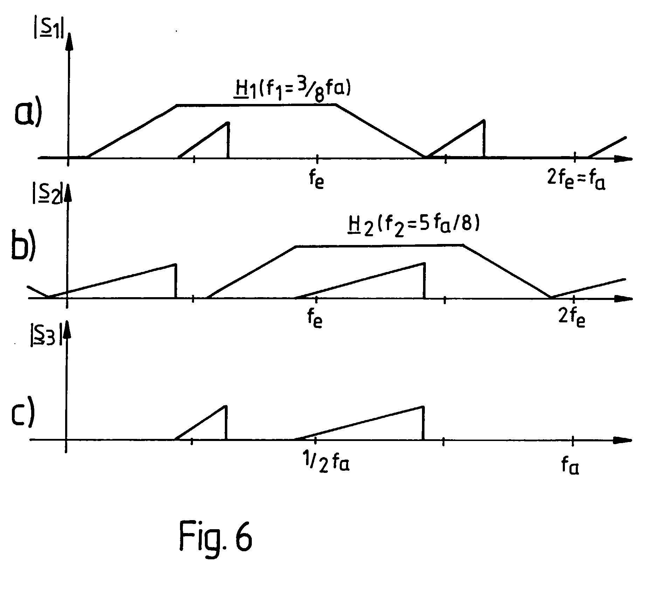

In Figur 6 ist ein Spektraldiagramm dargestellt für eine Funktion $\underline{H}1$ mit der Mittenfrequenz $f_1=3f_a/8$ und einer Übertragungsfunktion $\underline{H}2$ mit einer Mittenfrequenz $f_2=5f_a/8$. Die Filterung selbst erfolgt auch hier wie im Zusammenhang mit Figur 4 und 5 erläutert.

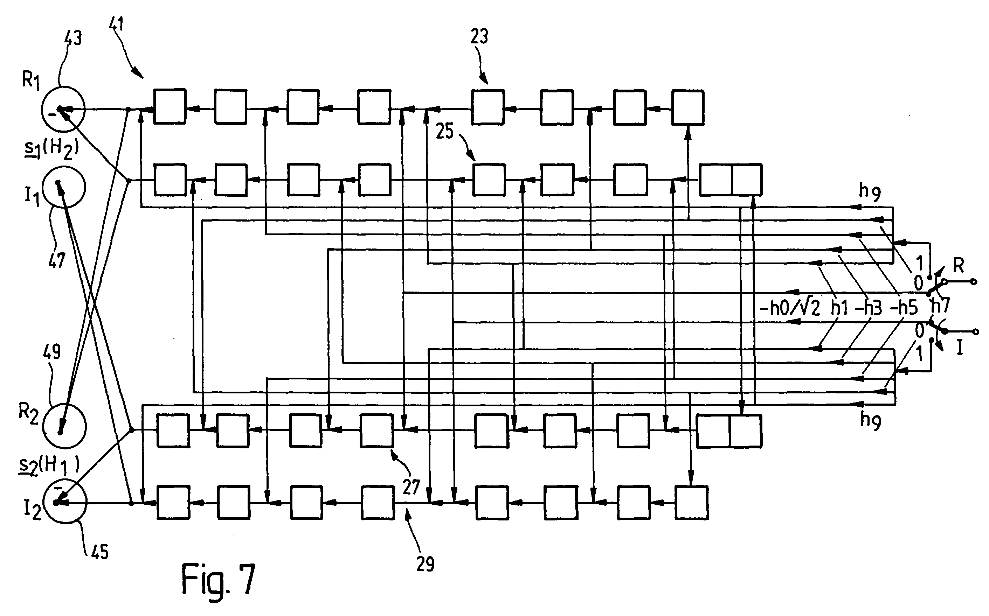

Figur 7 zeigt einen Verwendungsfall einer Schaltung gemäß Figur 2, die jedoch der Trennung eines komplexen Signals in zwei Einzelsignale dient. Die Struktur dieses FDM-Demultiplexers ergibt sich durch systematische Transponierung der Filterstruktur gemäß Figur 2, wobei die Zahl der Zustandsspeicher und der Multiplizierer gleich bleibt. Dabei resultiert für die angegebenen Verknüpfungen die Übertragungsfunktion $\underline{H}2$ für das obere Ausgangsklemmenpaar und die Übertragungsfunktion $\underline{H}1$ für das untere Ausgangsklemmenpaar.

Der Imaginärteil des ersten Signals $\underline{s}1$ ergibt sich aus einer Addition der beiden Ausgangssignale der Verzögerungsgliedketten 27,29. Der Realteil des zweiten Ausgangssignals $\underline{s}_2$ ergibt sich durch eine Addition der beiden Ausgangssignale der oberen Verzögerungsgliedketten 23,25.

Die Verknüpfung der Ausgangssignale der oberen beiden Verzögerungsgliedketten 23,25 zu dem Realteil des ersten Ausgangssignals und des zweiten Ausgangssignals erfolgt in einem Verknüpfungspunkt 43 beziehungsweise einem Verknüpfungspunkt 49. Die Verknüpfung der Ausgangssignale der beiden unteren Verzögerungsgliedketten 27,29 zum Imaginärteil des ersten und des zweiten Ausgangssignals erfolgt in einem Verknüpfungspunkt 47 beziehungsweise einem Verknüpfungspunkt 45.

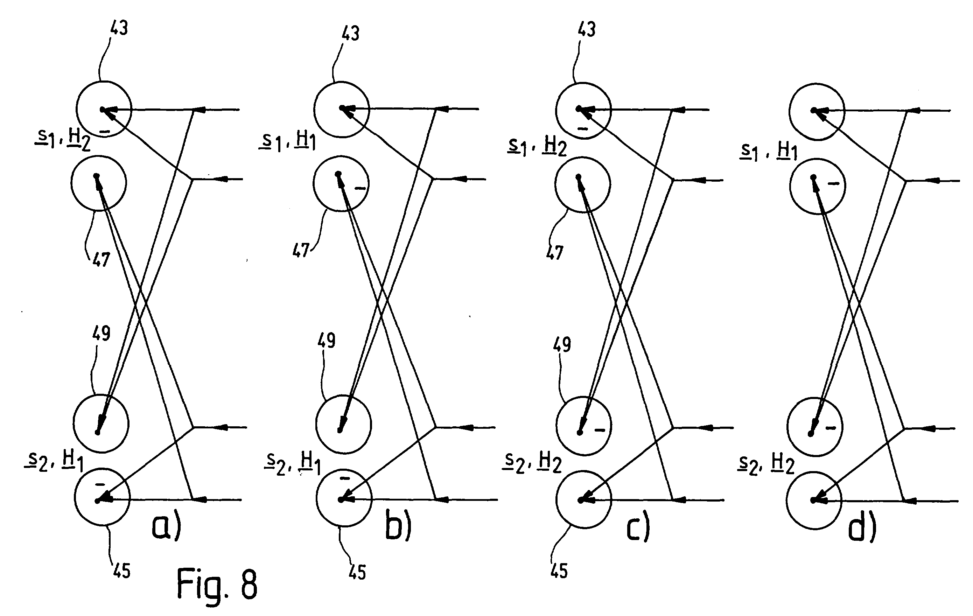

Auch in diesem Fall läßt sich die Übertragungsfunktion $\underline{H}1$ oder $\underline{H}2$ durch entsprechende Wahl der Verknüpfungsart der Signale in den Verknüpfungspunkt 43,45,47 und 49 einstellen. Die vier Möglichkeiten hierzu sind in Figur 8 dargestellt.

Auch bei dieser Demultiplexer-Schaltung läßt sich in einfacher Weise die Übertragungsfunktion verändern, so daß der Filteraufwand gering ist.

Selbstverständlich sind auch Ausführungsbeispiele mit anderen Filterlängen und anderen Mittenfrequenzen möglich.

**Patentansprüche**

1. Umschaltbare Frequenzweiche zum Zusammenfassen von mindestens zwei mit $f_e=f_a/2$ abgetasteten Signalen, mit einer entsprechenden Anzahl parallel zueinander angeordneten Einzelfilter, deren Ausgangssignale zu einem gemeinsamen FDM-Ausgangssignal mit doppelter Abtastfrequenz $f_a$ zusammengefaßt sind, **dadurch gekennzeichnet,** daß die komplexen Koeffizienten $\underline{h}(l)$ der Einzelfilter mit $l=-(N-1)/2$ bis $(N-1)/2$ und einer ungeraden Filterlänge N abwechselnd rein reelle und rein imaginäre Werte aufweisen, ausgenommen für $l = 0$, wofür der komplexe Koeffizient von der Form

$$\underline{h}(0)=\pm h(0)\ (1\pm j)/\sqrt{2}\ \text{ist,}$$

daß die Impulsantwort eines Halb-Band-Filters h(l) mit ausschließlich reellen Koeffizientenwerten und den Eigenschaften $h(l) = h(-l)$ für alle $|l| \leq (N-1)/2$ und $h(l)=0$ für $l=\pm 2, \pm 4,...$ auf den komplexen Träger einer Frequenz $f_m = (2m-1)\ fA/8$; $m = 0,\pm 1,\pm 2,...$, wobei $f_A = 1/T$ die Bezugsabtastfrequenz des Filters ist, moduliert ist zu $\underline{h}(l)=h(l) \cdot e^{j[l(2m-1)\pi/4+\varphi 0]}= h(l)\ e^{j[l(2m-1)+(2k-1)]\pi/4}$ mit $m =0,\pm 1,\pm 2,...$

und daß die Nullphase $\varphi 0$ dieses komplexen Trägers $\varphi_0 = (2k-1)\pi/4$ mit $k=0,\pm 1, \pm 2,...$ beträgt,

und daß zumindest in einem Einzelfilter die Vorzeichen einiger Koeffizienten beziehungsweise einiger Verknüpfungseinrichtungen zum Zusammenfassen von Teilsignalen einstellbar sind.

2. Umschaltbare Frequenzweiche der ungeraden Filterlänge N zum Zusammenfassen von mindestens zwei komplexwertigen Signalen $s_v = s_{rv} + js_{iv}$, $v=1,2,..$ der Abtastfrequenz $f_e$ zu einem komplexwertigen Signal der verdoppelten Abtastfrequenz $f_a = 2f_e$, **dadurch gekennzeichnet,** daß die komplexen Koeffizienten $\underline{h}_m(1)$ mit $1 = -(N-1)/2$ bis $(N-1)/2$ und einer ungeraden Filterlänge N aller Teilübertragungsfunktionen abwechselnd rein reelle und rein imaginäre Werte aufweisen, ausgenommen der mittlere Koeffizient für $1 = 0$, der von der Form

$$\underline{h}_m(0) = \pm h(0) (1 \pm j)/ _2 \text{ ist,}$$

daß die Impulsantwort eines Halb-Band-Filters $h(l)$ mit ausschließlich reellen Koeffizientenwerten und den Eigenschaften $h(l) = h(-l)$ für alle $|1| \leq (N-1)/2$ und $h(l)=0$ für $1=\pm 2, \pm 4,...$ auf je einem komplexen Träger einer Frequenz $f_m = (2m-1) f_a/8$ ; $m = 0,\pm 1,\pm 2,...$, wobei $f_a = 1/T$ die verdoppelte Ausgangsabtastfrequenz des Filters ist, moduliert ist zu $\underline{h}_m(l)=h(l) \cdot e^{jl[(2m-1)\pi/4+\varphi_0]} = h(l)j^k e^{j(l+1)(2m-1)\pi/4}$ mit $k,m =0,\pm 1,\pm 2$, wobei die Nullphase $\varphi_0$ dieses komplexen Trägers $\varphi_0 = (2m-1)\pi/4 + k\pi/2$ mit $k=0,\pm 1, \pm 2,...$beträgt, und daß zumindest für eine Teilübertragungsfunktion die Vorzeichen einiger Koeffizienten beziehungsweise Verknüpfungseinrichtungen veränderbar sind.

3. Umschaltbare Frequenzweiche nach Anspruch 2, **dadurch gekennzeichnet,**

daß ein erster (7) und ein zweiter (9) Filterzweig vorgesehen sind, deren jeder eine Realteil-Verzögerungsgliedkette (23,29) für die reellwertigen Filterkoeffizienten und eine Imaginärteil-Verzögerungsgliedkette (25,27) für die imaginären Filterkoeffizienten aufweist,

daß der Realteil-Kette (23) des ersten Filterzweigs (7) ein Summensignal $s_R = s_{r1} + s_{r2}$ zugeführt wird,

daß der Imaginärteil-Kette (25) des ersten Filterzweigs (7) ein Differenzsignal $d_R = s_{r1} - s_{r2}$ zugeführt wird,

daß der Imaginärteil-Kette (27) des zweiten Filterzweigs (9) ein Differenzsignal $d_I = s_{i1} - s_{i2}$ zugeführt wird, und

daß der Realteil-Kette (29) des zweiten Filterzweigs (9) ein Summensignal $s_I = s_{i1} + s_{i2}$ zugeführt wird, und

daß die Vorzeichen der zur Bildung der Differenzsignale $d_R, d_I$ benutzten Signale $s_{R1}$, $s_{R2}$, $s_{I1}$, $s_{I2}$ einstellbar sind, wobei durch Ändern der Vorzeichen die Filter-Übertragungsfunktion umschaltbar ist. (Figur 2).

4. Frequenzweiche nach Anspruch 1, 2 oder 3, **dadurch gekennzeichnet**, daß die Durchlaßbereiche der Filter bei einem beliebigen Paar von Mittenfrequenzen $f_m = (2m-1)f_a/8$ mit $m=1,2,3,4$ liegen.

5. Frequenzweiche nach einem der vorhergehenden Ansprüche, **dadurch gekennzeichnet,** daß sich die Duchlaßbänder der Teilübertragungsfunktionen der Filter ($\underline{H}1, \underline{H}2$) überlappen.

6. Frequenzweiche nach einem der vorhergehenden Ansprüche, **dadurch gekennzeichnet**, daß die Filter die Basisstruktur eines FIR-Filters aufweisen.

7. Frequenzweiche nach Anspruch 5, **dadurch gekennzeichnet**, daß die Filter mit Festkoeffizienten realisiert sind.

8. Frequenzweiche nach Anspruch 6, **dadurch gekennzeichnet**, daß die Festkoeffizienten in CSD-Code-Darstellung {0,1,-1} realisiert sind.

9. Verwendung einer Frequenzweiche gemäß einem der Ansprüche 1 bis 8 in transponierter Form zum Trennen eines komplexen FDM-Signals in mindestens zwei komplexe Teilsignale.

Fig. 1

EP 0 818 886 A2

Fig. 2

Fig. 3

EP 0 818 886 A2

**Fig. 4**

$|\underline{S}_1|$

a) $|H_1|$ — 15 — $f_e$ — $2f_e = f_a$

$|\underline{S}_2|$

b) $|\underline{H}_2|$ — 15 — $f_e$ — $2f_e$

$|\underline{S}_3|$

c) $f_a$

$|\underline{S}_1|$

a) $|\underline{H}_2|$ — $f_e$ — $f_a$

$|\underline{S}_2|$

b) $|\underline{H}_2|$ — $f_e$ — $2f_e$

$|\underline{S}_3|$

c) $\tfrac{1}{2}f_a$ — $f_a$

**Fig. 5**

Fig. 6

Fig. 7

Fig. 8

EP 0 818 886 A2

$|\underline{S}_1|$

$\Delta_u$    $1/2\, f_e$    $\Delta_0$  $f_e$    $2f_e = f_a$

$|\underline{S}_2|$

$\Delta_u$    $\Delta_0$  $f_e$    $2f_e = f_a$

$|\underline{S}_3|$

$1/2\, f_a$    $f_a$

Fig. 9

$\underline{s}_1(2kT)$  → $\uparrow 2$  $\underline{H}_1$ →

$+$  → $\underline{s}_3(kT)$

$\underline{s}_2(2kT)$  → $\uparrow 2$  $\underline{H}_2$ →

Fig. 10